# EUROPÄISCHE PATENTANMELDUNG

(11) **EP 2 720 265 A1**
(43) Veröffentlichungstag der Anmeldung: **16.04.2014**
(21) Anmeldenummer: 12188319.3
(22) Anmeldetag: 12.10.2012
(51) Int. Cl.: H01L 25/075, F21Y 105/00

(54) **Kühlkörper für Leuchtdiodenarray**

(71) Anmelder: IDEA Korb AG, 6343 Rotkreuz (CH)
(72) Erfinder: Willfratt, Christoph, 3183 Albligen (CH)
(74) Vertreter: Bremi, Tobias Hans

(57) **Zusammenfassung**

Die vorliegende Erfindung betrifft ein Leuchtdiodenarray (22) mit einer Vielzahl von flächenartig in einer Matrix angeordneten Leuchtdioden und mit einem Kühlkörper (10) zur Kühlung des Leuchtdiodenarrays (22), wobei der Kühlkörper (10) eine mit dem Leuchtdiodenarray (22) in thermischem Kontakt stehende Kontaktfläche und eine dieser Kontaktfläche abgewendet gegenüberliegend angeordnete und mit der Kontaktfläche in thermischem Kontakt stehende Kühlfläche (16) aufweist. Die Kühlfläche (16) ist mittels einer Vielzahl von kühlflächenseitig vom Kühlkörper (10) abragenden Elementen strukturiert, wobei Hohlräume für ein Kühlmedium zwischen den abragenden Elementen gebildet sind. Die abragenden Elemente sind hierbei stabförmige Kühlfinger (13), wobei diese Kühlfinger (13) jeweils in Richtung ihrer Längserstreckung vom Kühlkörper (10) abragen. Zudem betrifft die vorliegende Erfindung eine Kühlvorrichtung mit einem genannten Kühlkörper (10).

## Beschreibung

### TECHNISCHES GEBIET

Die vorliegende Erfindung betrifft ein Leuchtdiodenarray mit einer Vielzahl von flächenartig in einer Matrix angeordneten Leuchtdioden und mit einem Kühlkörper zur Kühlung solcher Leuchtdioden und die Erfindung betrifft eine Kühlvorrichtung mit einem solchen Kühlkörper.

### STAND DER TECHNIK

Leuchtdioden werden heutzutage verbreitet zur Erzeugung von Licht aus elektrischer Energie genutzt. Als mögliche Einsatzgebiete der Leuchtdiodentechnologie seien hier bspw. Industriestrahler, Bau- und Strassenscheinwerfer, Strassenbeleuchtungen, Tunnelleuchten, Sportscheinwerfer genannt. Es sind hierbei Leuchtdiodenchips (also Arrays von Leuchtdioden) mit Leistungen von etlichen Kilowatt bekannt. Bei derart hohen Leistungen wird im Prozess der Lichterzeugung ein beträchtlicher Anteil der elektrischen Energie in Wärme umgewandelt, welche sodann als Abwärme abgeführt werden muss. Dies insbesondere aus dem Grund, dass eine solche Leuchtdiode jeweils in einem bestimmten thermischen Bereich zu betreiben ist, um maximale Effizienz und minimale Beanspruchung der entsprechenden Strukturen sicherzustellen. Ein Betrieb der Leuchtdiode bei hohen Temperaturen (bspw. über 80° Celsius) setzt insbesondere deren Leistungsfähigkeit herab und schränkt die Lebensdauer ein; wird zudem eine maximale Temperatur überschritten, so kann die Leuchtdiode dadurch gar zerstört werden.

Eine aktive Kühlung der Leuchtdioden bzw. des Leuchtdiodenchips mit hoher Leistung ist somit also wünschenswert. Bei einer optimalen Kühlung kann bspw. eine Lebensdauer der Leuchtdioden von etwa 50'000 Stunden oder mehr erreicht werden. Abwärme wird meistens über Kühlkörper mit Kühlrippen aus Aluminium an ein Gehäuse des Leuchtdiodenchips abgegeben. Hierzu wir der Kühlkörper thermisch mit dem Gehäuse kontaktiert. Diese Art der Kühlung führt dazu, dass ein Wärmeleitmedium zwischen der Basisplatte des Leuchtdiodenchips und dem Alu- oder Kupfer-Kühlkörper aufgebracht werden muss. Als Wärmeleitmedium wird dann bspw. eine Wärmeleitpaste oder eine Wärmeleitfolie verwendet. Ist jedoch der Kühlkörper oder die Basisplatte des Leuchtdiodenchips nicht mit einer ausreichend kleinen Fertigungstoleranz produziert worden, entsteht insbesondere im Zentrum des Leuchtdiodenchips ein Wärmestau, was nach einiger Zeit zur beschleunigten Alterung und schlussendlich zur Zerstörung der einzelnen Leuchtdioden führt. Eine unzureichende oder übergrosse Menge an Wärmeleitpaste verursacht ebenfalls den genannten Wärmestau. Eine einzelne defekte Leuchtdiode im seriellen Verbund führt sodann zum Ausfall der zugehörigen Leuchtdioden im String und somit zur Leistungseinbusse an der abgegeben Lichtleistung des ganzen Arrays.

Aus der DE 20 2007 001 188 U1 ist bspw. ein Kühlmodul einer Leuchtdiode bekannt geworden, bei welchem ein Kühlkörper gelehrt wird, von welchem mehreren Kühlrippen zur Wärmeabfuhr abragen. Hierbei wird die Abwärme über die Kühlrippen an die Umgebungsluft abgegeben. Eine Wärmeabfuhrleistung einer solchen Konstruktion ist jedoch für Arrays aus Hochleistungsleuchtdioden unzureichend, was zu erhöhten Betriebstemperaturen der Leuchtdioden und damit zu den vorgenannten Problemen führt.

### DARSTELLUNG DER ERFINDUNG

Es ist somit eine Aufgabe der vorliegenden Erfindung, ein Leuchtdiodenarray mit einem Kühlkörper bereitzustellen, welcher die Abfuhr der Abwärme verbessert.

Diese und weitere Aufgaben werden durch einen Leuchtdiodenarray mit einer Vielzahl von flächenartig in einer Matrix angeordneten Leuchtdioden und mit einem Kühlkörper zur Kühlung des Leuchtdiodenarrays, wobei der Kühlkörper eine mit dem Leuchtdiodenarray in thermischem Kontakt stehende Kontaktfläche und eine dieser Kontaktfläche abgewendet gegenüberliegend angeordnete und mit der Kontaktfläche in thermischem Kontakt stehende Kühlfläche aufweist, wobei die Kühlfläche mittels einer Vielzahl von kühlflächenseitig vom Kühlkörper abragenden Elementen strukturiert ist, wobei Hohlräume für ein Kühlmedium zwischen diesen abragenden Elementen gebildet sind, dadurch gelöst, dass die abragenden Elemente stabförmige Kühlfinger oder Kühlstangen sind, wobei diese Kühlfinger jeweils in Richtung ihrer Längserstreckung vom Kühlkörper abragen.

Unter thermischem Kontakt ist ein Kontakt, insbesondere ein physischer Kontakt zwischen zwei Elementen gemeint, welcher bei vorherrschendem Temperaturgradienten einen Wärmeübertrag vom warmen Element auf das kalte Element erlaubt.

Ein Hohlraum ist insbesondere als ein Zwischenraum zwischen den abragenden Elementen zu verstehen. Werden bspw. Kühlrippen verwendet, wie aus dem Stand der Technik bekannt, so werden zwischen den Kühlrippen mehrere jeweils durch die Rippen abgetrennte Hohlräume bereitgestellt. Die vorliegende Erfindung führt diese Hohlräume zusammen, so dass vorzugsweise ein zusammenhängender Hohlraum zwischen den abragenden Elementen entsteht.

Ein Leuchtdiodenchip kann ein Leuchtdiodenarray vorgenannter Art bereitstellen. Hierbei kann ein solches Leuchtdiodenarray etwa 25 bis 1'000 oder bis zu 10'000 Leuchtdioden oder noch mehr bereitstellen, wobei dann eine entsprechende Anzahl (vorzugsweise grösser oder gleich der Anzahl Leuchtdioden) von Kühlfingern vorgesehen ist. Einzelne Leuchtdioden werden bspw. in Serie zusammengeschaltet, wobei dann diese seriellen Arrays in parallelen Strings verschaltet werden. Eine einzelne Leuchtdiode kann eine Leistung von 0.5 Watt bis 1 Watt aufweisen, womit dann ein Leuchtdiodenchip bis zu bspw. 5 bis 10 Kilowatt oder mehr aufweisen kann.

Es wird bevorzugt, dass wenigstens ein Kühlfinger, vorzugsweise genau ein Kühlfinger in einem kühlflächenseitigen Bereich eines maximalen Wärmeeintrags einer einzelnen, im Betrieb stehenden Leuchtdiode angeordnet ist und von der Kühlfläche vom Kühlkörper abragt.

Anders ausgedrückt, führt die Leuchtdiode, insbesondere über deren Emitter Abwärme auf die Kühlplatte ab. Diese Abwärme breitet sich vom Bereich des Eintritts oder Eintrages der Wärme auf die Kühlplatte aus und durchtritt den Kühlkörper aufgrund des thermischen Kontakts zwischen Kontaktfläche und Kühlfläche zur Kühlfläche hin. Kühlflächenseitig entsteht dann ein Bereich maximaler Temperatur aufgrund des Wärmeflusses vom besagten Emitter (da wo maximaler Wärmeintrag stattfindet); es entsteht eine Art Wärmezone. Um nun eine von einem Kühlfluid umströmbare Oberfläche dieser Wärmezone zu vergrössern, soll die Kühlfläche in dieser Wärmezone mindestens ein Kühlfinger, vorzugsweise am Ort der maximalen Oberflächentemperatur der Kühlfläche ohne Kühlfinger (also quasi der ebenen Kühlfläche oder der Grundfläche, auf welcher die abragenden Kühlfinger angebracht sind), angeordnet sein. Damit wird unter vorteilhafter Kühlflächenvergrösserung eine Wärmeleitung in Richtung der freien Enden der Kühlfinger erhöht, indem der Temperaturgradient zwischen diesem freien Ende des Fingers und dem Bereich, wo der Kühlfinger am Kühlkörper ansetzt, maximiert ist. Es wird dann also der Wärmeeintrag von der Leuchtdiode auf den Kühlköper auf eine vergrösserte Kühlfingeroberfläche übertragen, wobei die Wärme dann von dort aus in das den Finger umspülende Kühlmedium gelangt.

In einer Weiterbildung des Leuchtdiodenarrays mit dem Kühlkörper ragen die Kühlfinger jeweils im Wesentlichen rechtwinklig und vorzugsweise geradlinig vom Kühlkörper ab. Dies ist vorteilhaft, da die Herstellung der Kühlfingeranordnung so vereinfacht wird. Alternativ wäre es denkbar, dass krumme (vorzugsweise jedoch noch immer parallel zueinander verlaufende) und/oder schiefstehende Kühlfinger vorgesehen werden. Die Anordnung der Finger beeinflusst das Strömungsverhalten des Kühlmediums. Es ist also ein Optimum zwischen Durchflussrate und dem Strömungswiderstand, welchen die Kühlfinger als abragende Elemente dem Kühlmedium entgegensetzen, zu finden. Des Weiteren soll auch die Vermischung oder Verwirbelung des Kühlmediums zwischen den Kühlstäben oder -fingern eine Rolle.

Zumindest aus produktionstechnischen Gründen ist es bevorzugt, die Kühlfinger jeweils im Wesentlichen gleich geformt und regelmässig in zwei die Grundfläche, auf welcher die Kühlfinger angeordnet sind, aufspannenden und im Wesentlichen rechtwinklig zueinander stehenden Flächenrichtungen jeweils im Wesentlichen äquidistant anzuordnen. Die Anordnung der Kühlfinger kann also matrixartig sein, wobei die Kühlfinger (in einer Ansicht auf die Grundfläche) Elemente dieser flächenartig aufspannten Matrix bilden, zumindest insofern als sie als Matrixelemente Zeilen und Spalten der Matrix bilden. Diese Zeilen und Spalten verlaufen vorzugsweise geradlinig auf der Grundfläche, wobei die Abstände zwischen unmittelbar benachbarten Matrixelementen (also Kühlfmgern) in Zeilen- und/oder Spaltenrichtung vorteilhafterweise äquidistant sind. "Äquidistant" ist hier so zu verstehen, dass Paare von unmittelbar benachbarten Kühlfingern im Bereich nahe oder an der Grundfläche, wo sie also am Kühlkörper angebracht sind, paarweise gleich weit beabstandet sind. Die jeweiligen Abstände in Zeilenrichtung können unterschiedlich von jenen Abständen in Spaltenrichtung sein.

Eine alternative Ausgestaltung wäre eine Kühlfingeranordnung, welche keine regelmässigen matrixartigen Zeilen bzw. Spalten aufweist. Strukturell ausgedrückt kann es sich um ein quasikristalline oder ein glasartige Anordnung (in einer Ebene) handeln. Eine solche Anordnung von Kühlfingern ist bspw. denkbar, wenn die Wärmezonen (wie oben beschrieben) des wärmeerzeugenden Bauteils, das auf den Kühlkörper kontaktiert wird, eine solche Anordnung aufweisen.

Hinsichtlich der geometrischen Form der Kühlfinger wird bevorzugt, dass diese zylindrisch (im Sinne von nicht-konisch) oder konisch geformt sind, jeweils eine Länge von 1 Millimeter bis 50 Millimeter und eine Materialstärke an einem kühlkörperseitigen Ende des Kühlfingers (also gegenüberliegend dem freien Ende des Kühlfingers, an der Grundfläche) von 0.3 Millimeter bis 10 Millimeter aufweisen. Ein Verhältnis dieser Länge zu dieser Materialstärke kann jeweils vorzugsweise 1:1 bis 30:1, insbesondere 20:1 bis 25:1 betragen.

Es wird bevorzugt, dass die Kühlfinger aus Vollmaterial bereitgestellt sind. Dies erhöht deren Wärmeleitleistung entlang deren Längsrichtung und vereinfacht zudem das Herstellungsverfahren des Kühlkörpers.

Es wird weiter bevorzugt, dass unmittelbar benachbarte Kühlfinger (insbesondere in Zeilen- oder Spaltenrichtung einer allfälligen Matrixanordnung) um das 0.5-Fache bis 5-Fache der vorgenannten Materialstärke der Kühlfinger voneinander beabstandet sind. Besonders bevorzugt wird ein Verhältnis zwischen dem vorgenannten Abstand und der vorgenannten Materialstärke der Kühlfinger von 1:1.

Durch eine Vergrösserung der Abstände wird die Strömungsgeschwindigkeit zunehmen und der Kühleffekt wird zunehmen, da jedoch die Fläche nicht zunimmt, wird der Kühleffekt nur marginal verbessert.

Besonders bevorzugt wird, dass die Kühlfinger einstückig mit dem Kühlkörper bereitgestellt sind. In einer alternativen Ausgestaltung können die Kühlfinger bspw. auch im proximalen Bereich (d.h. gegenüber dem freien Ende) ein Gewinde aufweisen, wobei der Kühlkörper dann entsprechende Gegengewindebohrungen aufweist, in welche die Kühlfinger unter Gewindeeingriff mit flächigem Kontakt eingreifen, wobei ein distaler Bereich des Kühlfingers dann das frei abstehende Ende bildet. Ein Gewindekontakt erhöht hierbei das Ineinandergreifen der Flanken die Kontaktoberfläche zwischen Kühlfinger und Kühlkörper und wird daher einem grundsätzlich auch denkbaren reinen Materialschluss vorgezogen. Ein Materialschluss kann eine Alternative oder eine zusätzliche Sicherung der Befestigung der Kühlfinger im Kühlkörper sein. Es ist auch denkbar, dass Wärmeleitpaste zur verbesserten thermischen Kontaktierung angewendet wird.

Es ist weiter denkbar, dass die distalen Enden der Kühlfinger über eine weitere Kühlstruktur, bspw. eine Kühlplatte oder Kühlfolie, untereinander verbunden sind, bspw. um die Gesamtkühlfläche und/oder die mechanische Stabilität des Kühlkörpers insgesamt zu erhöhen oder aus strömungstechnischen Überlegungen zur verbesserten Führung des Kühlmediums. Erhöhte mechanische Stabilität kann insbesondere dann gefragt sein, wenn der Kühlkörper zu dünn ist, also bspw. eine Metallfolie mit Kühlfingern. Auch diese weitere Kühlstruktur kann mittels einer einstückigen Ausgestaltung oder mittels Form- und/oder Materialschluss geschehen.

Es wird bevorzugt, dass der Kühlkörper und/oder die Kühlfinger aus Metall, insbesondere aus Kupfer und/oder Aluminium und/oder Keramik und/oder einer Legierung daraus geformt sind.

Weiter wird bevorzugt, dass eine Querschnittsgestalt der Kühlfinger, zumindest abschnittsweise, im Wesentlichen kreisrund, rund oder vieleckig, insbesondere vier- fünf-, sechs- oder achteckig ist. Weiter ist denkbar, dass die Kühlfinger im Längsquerschnitt wellenförmig ausgebildet sind, d.h. sich in Längserstreckung unter einem Winkel von bis zu etwa 5 bis 20 Grad zur Longitudinalrichtung von der Längsachse weg erstrecken und danach wieder auf die Längsachse zu erstrecken.

Je nach Querschnittsform verändert sich die Oberfläche der Kühlfinger. Es wird also grundsätzlich eine grösstmögliche Kühlfläche angestrebt, welche fertigungs-/materialtechnisch unter Berücksichtigung der Produktionskosten erreichbar ist. Es ist hierbei im konkreten Fall auch zu beachten, dass Querschnittsform und Anordnung auch Einfluss auf das die Wärmeleitung entlang der Längserstreckung der Kühlfinger und auf das Strömungsverhalten des die Kühlfinger umspülenden, zirkulierenden Kühlmediums hat.

In einer Weiterbildung der vorliegenden Erfindung werden die Leuchtdioden direkt auf dem Kühlkörper angebracht. Es wird also auf eine Leiterplatte verzichtet. Dies ist vorteilhaft, da der Wärmefluss von der Leuchtdiode auf den Kühlkörper damit direkt geschieht und keine allenfalls wärmedämmend wirkenden Zwischenschichten (wie eine Leiterplatte) verwendet werden müssen. Vorzugsweise wird die Basisplatte gleichzeitig als Kühl- und als Montagebasisplatte für die Leuchtdiodenarrays genutzt. Für die Basisplatte wird vorzugsweise ein Aufbau aus einem Kupfer, Aluminium oder beschichteter Keramik verwendet. Zur Ansteuerung der Leuchtdioden werden dann Leiterbahnen bereitgestellt. Zur Isolierung der Leiterbahnen ist es vorteilhaft, die Bahnen auf mehrere Schichten bzw. Layer zu verteilen.

Bevorzugt ist eine Ausführungsform mit einer flexiblen, beschichteten Basisplatte, worauf die Leuchtdioden angeordnet sind.

Besonders bevorzugt sind Basisplatten, welche mit einer Folie beschichtet sind, um die Anschlüsse der Anode/Kathode anzubringen. Ein beispielhafter Basisplattenaufbau ist dann ein Grundkörper aus Messing, darauffolgend eine vorzugsweise elektrisch isolierende Beschichtung, worauf die Leiterbahnen der Anoden der Leuchtdioden aufgebracht werden, dann folgt eine weitere, vorzugsweise elektrisch isolierende Beschichtung, worauf die Leiterbahnen der Kathoden der Leuchtdioden aufgebracht werden, danach folgen die Leuchtdioden, welche dann mit einer Vergussmasse, bspw. auf Silikonbasis, vergossen werden.

Die so mit Leiterbahnen versehene Basisplatte dient dann sowohl als Kühlkörper als auch Montagesockel für die Leuchtdioden und enthält die Leiterbahnen, um Strom bzw. Spannung zu den jeweiligen Leuchtdioden in der richtigen Anordnung zu führen.

In einer alternativen zur vorgenannten Weiterbildung der vorliegenden Erfindung weist der Kühlkörper kontaktflächenseitig eine vorzugsweise plattenförmige Ausnehmung auf, wobei die Ausnehmung zur Aufnahme des Leuchtdiodenarrays dient. Dieses Leuchtdiodenarray kann dann eine Leiterplatte aufweisen. Hierzu ist der Kühlkörper dann eine massive Struktur, bspw. eine Metallplatte, in welche eine entsprechende Ausnehmung gefräst werden kann, sodass der Kühlkörper die für die bestimmungsgemässen Verwendungszwecke nötige Stabilität aufweist. Diese Ausnehmung ist dimensionsmässig vorzugsweise auf die Leiterplatte oder Grundplatte des einzusetzenden Leuchtdiodenchips abgestimmt, sodass diese Leiterplatte bündig in die Ausnehmung setzbar ist und mit ihrer Unterseite den die Kontaktfläche des Kühlkörpers bildende Bodenfläche der Ausnehmung kontaktiert. Allenfalls wird auch hier mit Wärmeleitpaste, Wärmeleitfolien oder dergleichen zur besseren Kontaktierung gearbeitet.

Weiter wird bevorzugt, dass der Kühlkörper eine vorzugsweise aus Vollmaterial, insbesondere aus Metall gebildete Kühlplatte umfasst, wobei diese Kühlplatte vorzugsweise parallel verlaufende Flächen aufweist und jeweils flächenseitig die Kontaktfläche und Teile der Kühlfläche bereitstellt. Die Dimensionen der Kühlplatte hängen vom zu kühlenden Objekt ab. Typischerweise ist die Platte flächenmässig grösser als dieses Objekt und 1 bis 10 Millimeter dick. Bei heutigen Standardanwendungen ist die Platte dann vorzugsweise 2 bis 4 Millimeter dick. Werden Komponenten mit höherer Leistung verwendet, so wird die Plattendicke vorteilhafterweise auf bis zu 10 Millimeter oder mehr erhöht.

Alternativ kann insbesondere eine (Metall)Folie, welche, je nach Konstruktion, genügend Stabilität zur Sicherung der Kühlfinger im zirkulierenden Medium erlaubt, als Grundkörper für den Kühlköper eingesetzt werden. Die Kühlfinger sind dann über Materialschluss auf die Folie zu bringen. An distalen Enden der Kühlfinger kann zur Stabilisierung eine weitere Folie angebracht sein.

In einer Weiterbildung der Erfindung kann eine Oberfläche des Kühlkörpers, insbesondere der Kühlfläche und/oder der Kühlfinger aufgeraut und/oder strukturiert und/oder mit einer Deckschicht überzogen sein. Bspw. können Kupferstrukturen vernickelt sein. Dies mit dem Ziel, die Kühlfläche zu vergrössern und/oder den Kontakt zwischen Kühlfläche und Kühlmedium zu verbessern (Benetzungs- und Reibungseigenschaften können berücksichtigt werden).

Die vorliegende Erfindung betrifft auch eine Kühlvorrichtung mit einem Kühlkörper mit Kühlfingern, wie oben beschrieben, für die verbesserte Kühlung eines Leuchtdiodenarrays. Die Kühlvorrichtung kann in einer Weiterbildung dadurch gekennzeichnet sein, dass die Kühlvorrichtung weiter ein Zirkulationsgefäss mit einem Kühlraum umfasst, wobei dieses Zirkulationsgefäss eine Montageöffnung umfasst, in welche der Kühlkörper vorzugsweise fluiddicht einsetzbar ist, derart, dass die Kühlfinger zumindest teilweise in den Kühlraum einragen und die Kontaktfläche zumindest teilweise nach aussen freisteht und der Kühlkörper die Montageöffnung fluiddicht schliesst. Das Zirkulationsgefäss kann also insbesondere im Wesentlichen becherförmig gebildet sein, wobei ein von Becherwandung umgebener Becherraum den Kühlraum bereitstellt. Zur Montage des Kühlkörpers auf dem Zirkulationsgefäss kann der vorzugsweise einstückige Kühlkörper entsprechende Montagemittel bereitstellen (bspw. flanschartige Befestigungsflächen zur Montage des Kühlkörpers auf dem Zirkulationsgefäss).

Der Kühlraum soll eine Grundfläche aufweisen, welche im Wesentlichen mindestens der von Kühlfingern überdeckten Fläche des Kühlkörpers entspricht, sodass der Kühlraum die Kühlfinger auch aufnehmen kann. Der Kühlraum soll von der Montageöffnung her gesehen so tief sein, dass die Kühlfinger im Kühlraum aufgenommen werden können. Vorzugsweise ist der Kühlraum also tiefer als die Kühlfinger lang sind, sodass die Kühlfinger optimal von Kühlmedium umspülbar im Kühlraum angeordnet sind. Besonders bevorzugt ist ein Aufbau, bei welchem die Kühlfinger in bis zu 2/3 oder mehr der Tiefe des Kühlraums einragen, damit nicht der Grossteil des Kühlfluids an der Kühlstruktur vorbeizieht.

In einer Weiterbildung der genannten Kühlvorrichtung umfasst das Zirkulationsgefäss weiter eine Einlassöffnung in den Kühlraum und eine vorzugsweise der Einlassöffnung gegenüberliegende Auslassöffnung aus dem Kühlraum. Eine Strömungsrichtung von Einlass- zu Auslassöffnung ist das vorzugsweise quer, insbesondere rechtwinklig zur Längserstreckung der Kühlfinger.

Das Zirkulationsgefäss ist vorzugsweise aus Kunststoff oder Metall geformt.

Die Kühlvorrichtung kann weiter einen Kühlkreislauf mit einem Kühlmedium, insbesondere einem Kühlfluid, vorzugsweise entionisiertem Wasser, allenfalls mit einem Frostmittelzusatz, umfassen, wobei der Kühlkreislauf über die Einlassöffnung und die Auslassöffnung den Kühlraum des Zirkulationsgefässes derart umfasst, dass die in den Kühlraum einragenden Kühlfinger mit im Kühlkreislauf zirkulierendem Kühlmedium umspülbar bereitgestellt sind.

Die Kühlvorrichtung kann in einer Weiterbildung eine Zirkulationspumpe zur Zirkulation des Kühlmediums im Kühlkreislauf und/oder ein Expansionsgefäss zum Volumenausgleich und/oder einen Kondensator zur Kühlung des Kühlmediums umfassen. Zudem ist denkbar, dass die aus der vom wärmeerzeugenden Bauteil stammende Wärmeenergie über den Kühlkreislauf zu einem spezifischen Zweck genutzt wird. Es ist bspw. denkbar, dass die an den Kühlkreislauf abgegebene Wärmeenergie im Bereich Vorheizung oder Hauptheizung als zusätzliche Quelle genutzt wird. Dies können Standardheizsysteme wie bspw. eine Wärmepumpe Luft/Luft oder Luft/Sole sein. Der Vorlauf/Rücklauf beträgt je nach Heizsystem ca. 35 bis 45 Grad. Die Rücklauftemperatur der Leuchtdiodenkühlung kann gut auf etwa 45 bis 60 Grad ansteigen. Diese Energie kann durch einen Bypass direkt in die Rücklaufleitung des Heizkreislaufes eingespiesen werden. Somit wird die nachtfolgende Aufheizphase des Heizkessels oder der Wärmepumpe deutlich reduziert, womit elektrische oder chemische Brennstoffenergie eingespart wird. Bei Anlagen, deren Betriebstemperatur unter null Grad Celsius liegt, bspw. in Industriehallen, ist es dann vorteilhaft, die zwei Flüssigkeitskreislaufsysteme getrennt zu betreiben und diese in einen Wärmetauscher oder bspw. in einen Mehrschichten-Boiler für Solar anlagen sein zu führen.

Der vorgenannte Kühlkörper oder die vorgenannte Kühlvorrichtung kann also zur Kühlung des Leuchtdiodenarrays mit einer Vielzahl von einzelnen, flächenartig in einer Matrix angeordneten Leuchtdioden verwendet werden, womit es möglich ist, die Betriebstemperatur der Strukturen um die und in den Leuchtdioden eines Leuchtdiodenchips abzusenken, bspw. auf etwa 40° Celsius oder weniger in einer Umgebung der Leuchtdioden. Dies erlaubt dann die Verwendung von Kunststoffmaterialen, wo bis anhin kostenintensivere Werkstoffe wie bspw. Aluminium eingesetzt werden mussten. Somit ist eine weitere Senkung der Herstellungskosten bei lebensdaueroptimiertem Betrieb eines Leuchtdiodenchips möglich. Auch können die Strukturen leichter gebaut werden.

Weitere Ausführungsformen sind in den abhängigen Ansprüchen angegeben.

### KURZE BESCHREIBUNG DER ZEICHNUNGEN

Bevorzugte Ausfühmngsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: in perspektivischer Ansicht von oben eine Ausführungsform eines erfindungsgemässen Kühlkörpers mit Kühlfingern und mit einem Leuchtdiodenchip mit Kunststoffrahmen;
- Fig. 2: zeigt den Gegenstand nach Fig. 1 in einer perspektivischen Ansicht von seitlich unten;
- Fig. 3: zeigt den Gegenstand nach Fig. 1 in einer perspektivischen Ansicht von unten;
- Fig. 4: eine Explosionsdarstellung des Gegenstandes nach Fig. 1 von schräg oben;
- Fig. 5: die Explosionsdarstellung nach Fig. 4 von seitlich unten;
- Fig. 6: in einer perspektivischen Ansicht eine erfindungsgemässe Kühlvorrichtung umfassend den Kühlkörper nach Fig. 1 mit einem Leuchtdiodenarray und einem Kunststoffrahmen und ein Zirkulationsgefäss, in welches der Kühlkörper eingesetzt ist;
- Fig. 7: Kühlgefäss der Kühlvorrichtung gemäss Fig. 6; und
- Fig. 8: die Kühlvorrichtung nach Fig. 6 mit einem Kühlkreislauf umfassend eine Zirkulationspumpe, ein Expansionsgefäss und einen Kondensator mit Ventilator.

### BESCHREIBUNG BEVORZUGTER AUSFÜHRUNGSFORMEN

Nachfolgend werden bevorzugte Ausführungsformen der vorliegenden Erfindung beschrieben, wobei als wärmeerzeugendes Bauteil ein Leuchtdiodenarray 22 verwendet wird. Es ist allerdings denkbar, dass andere wärmeerzeugende Bauteile erfindungsgemäss gekühlt werden, insbesondere elektronische Bauteile, bei welchen Abwärme über auf einer Fläche verteilten Wärmezonen (mit einer jeweiligen Ausdehnung von etwa 0.5 bis 10 Millimeter um eine lokale Höchsttemperatur, bspw. 30° bis 100° Celsius oder mehrere hundert Grad Celsius) abzuführen ist.

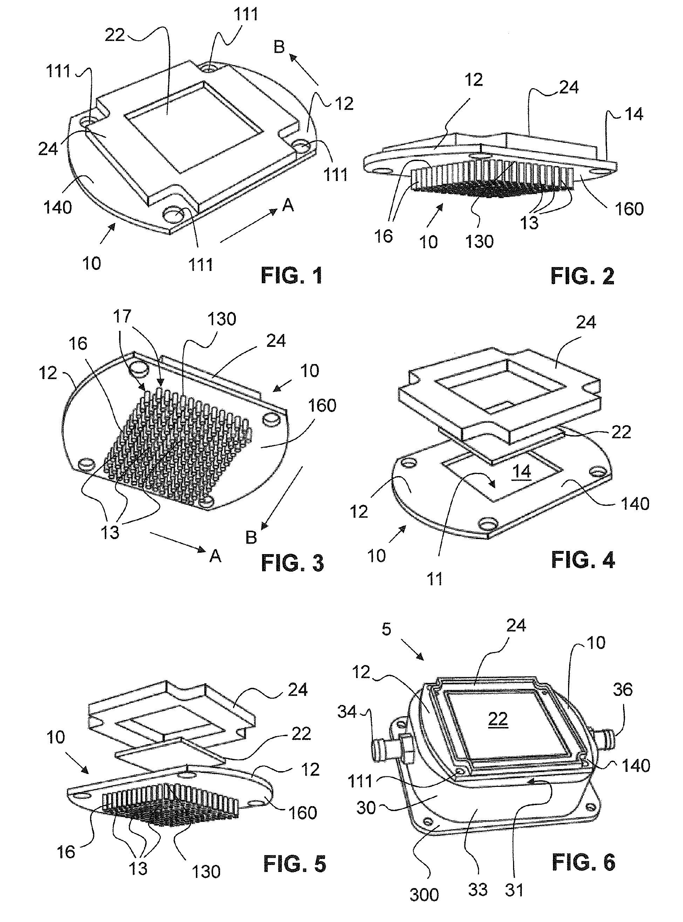

Die **Figs. 1** bis **3** zeigen eine exemplarische Ausführungsform eines Kühlkörpers 10 mit dem Leuchtdiodenchip oder -array 22 in verschiedenen perspektivischen Darstellungen.

**Figuren 4** und **5** zeigen eine Explosionsdarstellung des Gegenstandes nach Figs. 1 bis 3.

In den Figs. 1 bis 5 ist jeweils eine Kühlplatte 12 mit einer viereckigen Grundform und mit einer Dicke von im Wesentlichen 1.5 bis 3 Millimeter, insbesondere 2 Millimeter erkennbar, welche den Kühlkörper 10 bildet. Eine Oberseite 140 der Platte 12 stellt die Kontaktfläche 14, eine Unterseite 160 der Platte 12 teilweise die Kühlfläche 16 bereit; die Oberseite 140 und die Unterseite 160 der Kühlplatte 12 verlaufen in parallelen Ebenen zueinander.

Breitseiten der Grundform der Platte 12 sind in einer Draufsicht konvex nach aussen gewölbt, Längsseiten der Platte 12 verlaufen geradlinig. Die Auswölbung beträgt an ihrer Maximalstelle jeweils etwa 25% der Länge der Längsseite.

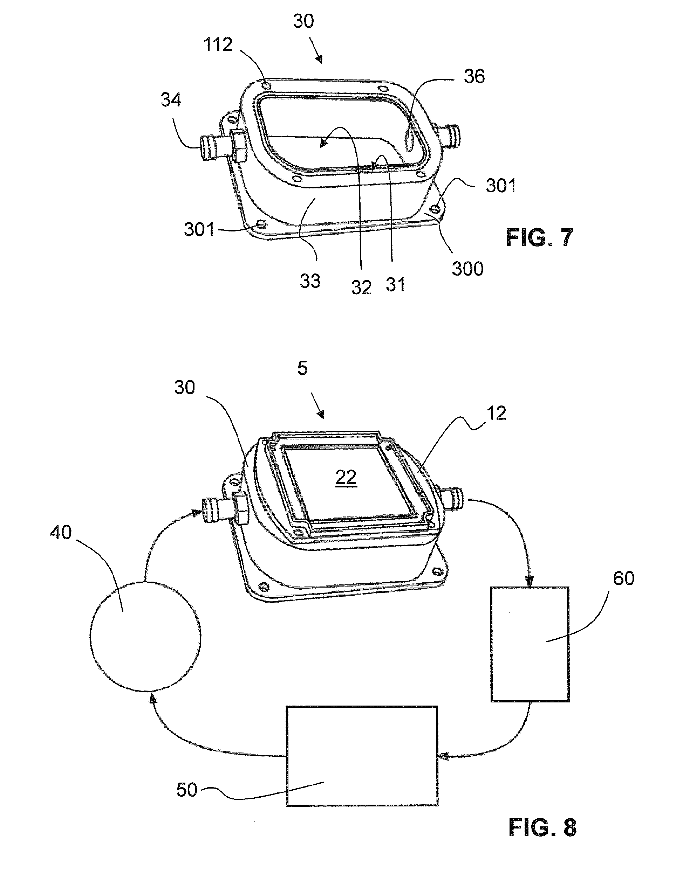

Die Kühlplatte 12 weist randbeabstandet, nahe der vier Ecken der Platte 12 (bez. einer Draufsicht auf die Platte 12) jeweils eine Bohrung 111 auf. Die Bohrungen 111 erstrecken sich von der Plattenoberseite 140 durch zur Plattenunterseite 160. Der Abstand zwischen den Zentren der Bohrungen 111 beträgt längsseitig der Platte 12 etwa 35 Millimeter und breitseitig ebenfalls etwa 35 Millimeter. Auf dem Zirkulationsgefäss 30 sind weitere Bohrungen 112 vorgesehen (s. Fig. 7), welche mit den vorgenannten Bohrungen 111 korrespondieren, sodass eine Verbindung, bspw. eine Schraubverbindung, zwecks Befestigung möglich ist.

Kontaktflächenseitig (d.h. an der Oberseite 140) ist mittig zwischen den vier Bohrungen 111 eine quader- oder plattenförmige Ausnehmung 11 eingelassen. Eine Tiefe der Ausnehmung 11 beträgt etwa 50% der Dicke der Kühlplatte 12. Eine Bodenfläche der Ausnehmung 11 verläuft parallel zur Oberfläche 140 der Platte 12 und stellt die Kontaktfläche 14 bereit. Längsseiten der Ausnehmung 11 verlaufen parallel zu den Längsseiten der Platte 12 und erstrecken sich etwa über deren halbe Länge. Breitseiten der Ausnehmung 11 verlaufen parallel zu den Breitseiten der Platte 12 und erstrecken sich ebenfalls etwa über deren halbe Länge.

Von der Plattenunterseite 160 ragen 206 geradlinige Kühlfinger 13 mit einem quadratförmigen Querschnitt mit einer Seitenlänge von im Wesentlichen 1 Millimeter ab. Diese Kühlfinger 13 und Teile der Unterseite 160 der Platte 12 (solche Teile der Unterseite 160, welche Hohlräume zwischen den Kühlfingern 13 begrenzen, oben als "Grundfläche" bezeichnet) stellen die Kühlfläche 16 bereit, welche im Betrieb mit einem Kühlmedium umspült wird.

Die Kühlfinger 13 sind derart ausgerichtet, dass jeweils zwei ihrer Seitenflächen parallel zur Längsseite der Platte 12 in Flächenrichtung A stehen. Es ragen fünfzehn jeweils geradlinig in Flächenrichtung A (d.h. rechtwinklig zur B-Richtung) und damit untereinander parallel verlaufende Reihen von Kühlfinger 13 von der Unterseite 160 der Platte 12 ab. Diese Reihen in A-Richtung bilden Zeilen oder Spalten einer Matrix, wobei die Kühlfinger 13 die Matrixelemente darstellen. Unmittelbar benachbart stehende dieser Reihen sind in B-Richtung (d.h. senkrecht zu den Längsseiten) jeweils etwa 1 Millimeter voneinander beabstandet. Ein Abstand zwischen zwei unmittelbar benachbarten Kühlfingern 13 in A-Richtung beträgt ebenfalls etwa 1 Millimeter. Die Kühlfinger 13 bilden also eine flächenartig angeordnete Matrix von Kühlfingern 13 welche in A- und B-Richtung jeweils paarweise äquidistant um 1 Millimeter beabstandet sind. Es ist denkbar, dass die Abstände zwischen Kühlfingern 13 in A-Richtung und in B-Richtung unterschiedlich sind (bspw. im Verhältnis 1:1.1 bis 1:5). Im Regelfall ist die Anordnung der Kühlfinger 13 durch die Anordnung der Leuchtdioden im Leuchtdiodenarray vorgegeben.

In einer Draufsicht von unten ist dann die Unterseite 160 im von der Kühlfingeranordnung überdeckten Bereich der Unterseite 160 zu etwa 30% mit Kühlfingern 13 bedeckt (im Grenzfall vieler Kühlfinger 13). Sind die Kühlfinger 13 nun bspw. 5 Millimeter lang, so vergrössert sich die Kühlfläche 16 um etwa einen Faktor 10 gegenüber einer Struktur ohne Kühlfinger 13. Werden die Reihen von Kühlfingern 13 in B- oder A-Richtung durchgängig verbunden (sodass jede Reihe eine Kühlrippe darstellt) so ist die Flächenvergrösserung durch die Rippen nur etwa halb so gross.

Die oben beschriebene Anordnung von Kühlfingern 13 bildet mit den freistehenden Bereichen der Unterseite 160 der Kühlplatte 12 die Kühlfläche 16.

In den Reihen von Kühlfingern 13, welche bez. der Richtung A aussen stehen (d.h. in der vordersten und der hinterste Reihe bez. A-Richtung), sind jeweils dreizehn Kühlfinger 13 angeordnet; in den zwölf dazwischen liegenden Reihen sind jeweils fünfzehn Kühlfinger 13 angeordnet.

Ein solcher Kühlkörper 10 mit der Kühlplatte 12 kann aus Kupfer (vorzugsweise vernickelt) oder Aluminium oder einer Legierung gefräst, gegossen, gestanzt sein, sodass die Kühlfinger 13 einstückig mit der Kühlplatte 12 bereitgestellt sind. Dies erlaubt den optimalen Wärmeübertrag von der Kühlplatte 12 in die Kühlfinger 12.

Alternativ ist denkbar, dass die Kühlfinger 13 mit einem endseitigen Gewinde in kühlflächenseitigen Gewindebohrungen der Kühlplatte 12 befestigt sind. Die Kühlfinger 13 können zusätzlich oder alternativ über einen Materialschluss mit der Kühlplatte 12 verbunden sein. Es kann auch Wärmeleitpaste zur besseren thermischen Kontaktierung eingesetzt werden.

Der in die Ausnehmung 11 eingesetzte Leuchtdiodenchip 22 (vorzugsweise auch über ein Wärmeleitmedium, bspw. nach der Lehre der DE 20 2007 001 188 U1 auf die Kühlplatte 12 aufgebracht) weist eine Anordnung von 206 Leuchtdioden auf, wobei die jeweiligen kontaktflächenseitigen Emitter der Leuchtdioden in der Ausnehmung 11 jeweils einem einzelnen Kühlfinger 13 über die Dicke der Platte direkt gegenüberliegend angeordnet sind. Damit ist jeder kontaktflächenseitigen Leuchtdiode, bzw. jedem Emitter der Leuchtdiode kühlflächenseitig ein einzelner Kühlfinger 13 zugeordnet, welcher in einer Richtung senkrecht zur Kontaktfläche 14 über die Dicke der Kühlplatte 12 im Bereich der Ausnehmung 11 beabstandet liegt, womit ein direkter und optimaler Wärmepfad von jedem Emitter in einen Kühlfinger 13 und von da dann über dessen Oberfläche ins Kühlmedium bereitgestellt ist. Dadurch wird ein maximaler Wärmeeintrag von der Leuchtdiode in das Kühlmedium erreicht.

Durch Verwendung von Materialien mit hoher Wärmeleitfähigkeit (bspw. Kupfer, Aluminium oder andere Metalle oder Legierungen) wird ein Maximum an Wärme von der Leuchtdiode in den zugeordneten Kühlfinger 13 transportiert. Dadurch, dass der Kühlfinger 13 mit einem Kühlmedium, insbesondere mit einem Kühlfluid wie bspw. entionisiertem Wasser mit einem Frostschutzmittel oder flüssigem C₆F₁₄, umspült ist, welches ebenfalls eine hohe Wärmekapazität aufweist, kann ein Maximum an Wärme von der Leuchtdiode über den genannten Wärmepfad über den Kühlfinger 13 an das Kühlmedium abgegeben werden.

Die Ausnehmung 11 und damit das darin aufgenommene LED-Array 22 können auch verdreht um eine rechtwinklige Achse zur Kontaktfläche 14 angeordnet sein.

Ein Fachmann weiss die Geometrie der Kühlplatte 12 und der Kühlfinger 13 mitsamt deren Anordnung an die situativen Anforderungen (insbesondere durch das zu kühlende Bauteil, bspw. die Anordnung der Leuchtdioden auf dem Leuchtdiodenarray vorgegeben) anzupassen.

Ein Kunststoffrahmen 24 umrandet den Leuchtdiodenchip 22, sodass dessen Leuchtdioden frei nach oben abstrahlen können. In der Höhe überragt der Kunststoffrahmen 24 den Chip 22 um 1 bis 2 Millimeter. Auf den Leuchtdiodenchip 22 kann dann eine schützende Silikonmasse aufgetragen werden, welche seitlich vom Kunststoffrahmen 24 begrenzt und gehalten wird.

In einer anderen, nicht dargestellten Ausführungsform ist kein Rahmen um die Leuchtdiodenarrays oder den Leuchtdiodenchip bereitgestellt. Die Leuchtdioden werden direkt auf die Kühl- bzw. Basisplatte, bspw. das PCB, welches Epoxidharz- oder Alubeschichtet ist, angebracht.

Im Finish werden dann die Leuchtdioden mit einer Silikonmasse vergossen; die Randbereiche der Silikon-Vergussmasse zum Trägermaterial (dem PCB) werden mit einem Klebstoff auf Silikonbasis oder 2K-Leim gemacht verklebt.

Die **Fig. 6** zeigt eine erfindungsgemässe Kühlvorrichtung 5 mit einem Zirkulationsgefäss 30. Das unten geschlossene Zirkulationsgefäss 30 ist in **Fig. 7** dargestellt. Eine Grundfläche dieses Zirkulationsgefässes 30 überragt eine Grundform der Kühlplatte 12, derart, dass die Kühlplatte 12 von oben auf eine Montageöffnung 31 aufsetzbar ist. Hierbei steht die Kühlplatte 12 mit ihrer Unterseite 160 seitlich auf einer Wandung 33 des Zirkulationsgefässes 30 auf, wobei die Kühlfinger 13 in den vom dieser Wandung 33 umgebenen Kühlraum 32 einragen. Über die Bohrungen 111 kann der Kühlkörper 10 auf dem Zirkulationsgefäss 30 festgeschraubt werden. Die Verbindung soll zum Kühlraum 32 hin fluiddicht sein, sodass kein Kühlmedium vom Gefässinneren nach aussen dringen kann, wenn der Kühlkörper in die Montagöffnung 31 eingesetzt und befestigt ist. Es können dazu entsprechende Dichtungen vorgesehen sein.

Auf einer der Montageöffnung 31 gegenüberliegenden Seite des Zirkulationsgefässes 30 weist das Gefäss 300 eine Bodenplatte 300 auf, welche den Kühlraum 32 nach unten abschliesst und die Wandung 33 seitlich überragt. Diese überstehenden Abschnitte weisen durchgehende Bohrungen 301 (s. Fig. 7) auf, mittels welcher das Zirkulationsgefäss 30 samt Kühlkörper 10 (bzw. Kühlplatte 10) und Chip 22 befestigbar ist. Die Wandung 33 weist links in Fig. 6 eine Einlassöffnung 34 und rechts in Fig. 6 eine Auslassöffnung 36 auf. Diese Öffnungen 34, 36 stellen SNAP-in-Verbindungsstutzen zum Schnellverschluss mit Silikonschläuchen bereit. Über diese Silikonschläuche kann dann der Kühlkreislauf hergestellt werden. Ein typischer Innendurchmesser eines solchen Silikonschlauches und der Öffnungen kann etwa 5 bis 10 Millimeter betragen.

Die Kühlplatte 12 mit den Kühlfingern 13 wird also direkt auf das Zirkulationsgefäss 30 montiert. Die durch die Leuchtdioden produzierte Wärme wird über die Kühlplatte 12 und weiter über die Kühlflüssigkeit an das Kühlmedium und von diesem dann an einen sekundären Kühlkreislauf übergeben. Ein aktives Element des sekundären Kühlkreislaufs kann aus einem Kondensator 60 bestehen, welcher bei vordefinierter Last mit einem Ventilator unterstützt wird, womit die Abwärme durch Konvektion an die Umgebung abgeben werden kann.

In Fig. 8 ist ein Kühlkreislauf mit einem Zirkulationsgefäss 30, einer Zirkulationspumpe 40, einem Expansionsgefäss 50 und einem Kondensator 60 mit Ventilator erkennbar. Als Antriebselement 40 des Kühlfluids kann bspw. ein wartungsfreier bürstenloser Motor (Zirkulationspumpe 40) mit einer Zirkulationsleistung von bspw. etwa 6 Liter Flüssigkeit pro Minute eingesetzt werden. Das Expansions- oder Ausgleichsgefäss 50 dient als Temperaturkontrolle und/oder Füllsystem und wird vorzugsweise nach dem Kondensator 60 in den Kühlkreislauf eingesetzt ist.

Ein Fachmann weiss die Komponenten des Kühlkreislaufes (Zirkulationsgefäss 30, Zirkulationspumpe 40 oder Antriebselement 40, Expansionsgefäss 50, Kondensator 60 ev. mit Ventilator,...) den Anforderungen entsprechend vorzusehen. Die Verbindungen des Kühlkreislaufs können hierbei bspw. über Flex-Schläuche aus Silikon mit SNAP-in Steckverbindungen realisiert werden.

Eine elektronische Steuerung regelt die Zufuhr der elektrischen Energie. Es ist denkbar, den Leuchtdiodenchip 22 mit Pulsweitenmodulation von 0 auf 100% Leuchtstärke zu steuern. Vorzugsweise die gleiche oder eine andere elektronische Steuerung übernimmt die Reduzierung der Leistung falls ein Temperaturwächter eine zu hohe Temperatur signalisiert. Die Temperatur wird also vorzugsweise elektronisch kontrolliert und die Energiezufuhr des Leuchtdiodenarrays 22 automatisch (bspw. per Pulsweitenmodulation) heruntergeregelt, sobald das Leuchtdiodenarray 22 in einem unerlaubten Temperaturbereich betrieben wird. Dieser Temperaturwächter kann hierbei einen Temperatursensor umfassen, welcher bspw. auf der Kontaktfläche 14 oder allenfalls auf der Kühlfläche 16 oder einem Kühlfinger 13 angebracht ist. Es können auch mehrere Temperatursensoren an verschiedenen Stellen angebracht sein.

Das Spannungssignal für die Leuchtdioden wird als reine DC-Spannung ausgegeben. Auftretende "Spikes" und Spannungsübertritte nach der Sättigung der Siliziumspezifischen Durchlassspannung werden durch einen HF/NF-Filter minimiert.

Die elektronische Steuerung der Leuchtdioden ist vorteilhafterweise in zwei Bereiche unterteilt, den Bereich "Power" und den Bereich "Sense".

Die Steuerung (Bereich "Sense") weist hierbei vorzugsweise folgende Merkmale auf:
- Um die Sicherheit zu gewährleisten, wird die Temperatur des Kühlkörpers oder der Kühlflüssigkeit gemessen. Sobald die Temperatur einen vordefinierten Grenzwert (bspw. 80 Grad Celsius) überschreitet, schaltet die Regelstelle die Leuchtdiode per PWM (Pulsweitenmodulation) stufenweise herunter, vorzugsweise von 100 % der Leistung auf minimal 5% der Leistung. Durch die restlichen 5% der Leistung ist dann für einen Betrachter klar erkennbar, ob die leistungsreduzierte Leuchtdiode noch funktioniert und die Leistung aufgrund von Überhitzung reduziert wurde. Entspannt sich die Situation und die Leuchtdiode kühlt ab und die Temperatur unterschreitet den erwähnten Temperaturgrenzwert, so schaltet die Regelung die Leistung zur Beleuchtung wieder stufenweise hoch bis vorzugsweise auf 100% der Leistung.
- Die Steuerelektronik ist so aufgebaut, dass jede einzelne Steuerung und damit jede einzelne Leuchtdiode, vorzugsweise ab Produktion eine eindeutige Identifikation, bspw. eine Nummer, bekommt. Diese Identifikation ist in einer Software abrufbar und kann einer Software zur Lichtsteuerung übergeben und von dieser berücksichtigt werden. Somit lassen sich Leuchtdioden gruppenweise zusammenfassen. Jede einzelne dieser Leuchtgruppen kann die Leistung der einzelnen Leuchtdioden separat steuern und/oder der Leuchtgruppe wird eine vorbestimmte Leistung, bspw. 200 Watt, zugewiesen. So kann dann eine Leuchtgruppe zur Maschinenbeleuchtung mit 80% der Maximalleistung dieser Leuchtgruppe, eine Leuchtgruppe zur Beleuchtung eines QS-Bereichs mit 100% der Maximalleistung dieser Leuchtgruppe oder eine Leuchtgruppe zur Beleuchtung eines Durchgangs- oder eines Toilettenbereichs mit 60% der jeweiligen Maximalleistung der betreffenden Leuchtgruppe beleuchtet werden. Dies optimiert den Energieverbrauch.
- Die Ansteuerung der einzelnen Leuchtgruppen wird dann vorzugsweise durch eine Software am PC oder durch einen Master-"Schalter" gesteuert. Jede einzelne Steuerung einer Leuchtdiode enthält einen 4-Draht-BUS und ein Funkverbindungsanschluss (Sender und Empfänger). Eine bidirektionale Verbindung ermöglicht nun, die exakten Daten jeder Leuchtdiode zu definieren und auch die aktuellen Werte jeder Leuchtdiode als Feedback zu Handen einer Software abzufragen. Zusätzliche Sensoren wie Beleuchtungsstärke oder Bewegungsmelder können als Informationsquellen genutzt werden, um jeder Situation der aktuellen Beleuchtung gerecht zu werden.

### BEZUGSZEICHENLISTE

- 5: Kühlvorrichtung
- 10: Kühlkörper
- 11: Ausnehmung
- 111: Bohrung
- 112: Bohrung
- 12: Kühlplatte
- 13: Kühlfinger
- 130: Ansatzpunkt
- 14: Kontaktfläche
- 140: Oberseite der Platte 12
- 16: Kühlfläche
- 160: Unterseite der Platte 12
- 17: Kühlflächenseitiger Bereich maximalen Wärmeeintrags durch eine Leuchtdiode
- 22: Leuchtdiodenarray

- 24: Kunststoffrahmen
- 30: Zirkulationsgefäss
- 300: Bodenplatte
- 301: Bohrung
- 31: Montageausnehmung
- 32: Kühlraum
- 33: Wandung
- 34: Einlassöffnung
- 36: Auslassöffnung
- 40: Zirkulationspumpe
- 50: Expansionsgefäss
- 60: Kondensator
- A, B: Flächenrichtung

## Patentansprüche

1. Leuchtdiodenarray (22) mit einer Vielzahl von flächenartig in einer Matrix angeordneten Leuchtdioden und mit einem Kühlkörper (10) zur Kühlung des Leuchtdiodenarrays (22), wobei der Kühlkörper (10) eine mit dem Leuchtdiodenarray (22) in thermischem Kontakt stehende Kontaktfläche (14) und eine dieser Kontaktfläche (14) abgewendet gegenüberliegend angeordnete und mit der Kontaktfläche (14) in thermischem Kontakt stehende Kühlfläche (16) aufweist, wobei die Kühlfläche (16) mittels einer Vielzahl von kühlflächenseitig vom Kühlkörper (10) abragenden Elementen strukturiert ist, wobei Hohlräume für ein Kühlmedium zwischen den abragenden Elementen gebildet sind, **dadurch gekennzeichnet, dass** die abragenden Elemente stabförmige Kühlfinger (13) sind, wobei diese Kühlfinger (13) jeweils in Richtung ihrer Längserstreckung vom Kühlkörper (10) abragen.

2. Leuchtdiodenarray (22) mit einem Kühlkörper (10) nach Anspruch 1, **dadurch gekennzeichnet, dass** wenigstens ein Kühlfinger (13), vorzugsweise genau ein Kühlfinger (13) in einem kühlflächenseitigen Bereich (17) eines maximalen Wärmeeintrags einer einzelnen, im Betrieb stehenden Leuchtdiode angeordnet ist.

3. Leuchtdiodenarray (22) mit dem Kühlkörper (10) nach einem der vorangehenden Ansprüche, **dadurch gekennzeichnet, dass** die Kühlfinger (13) jeweils im Wesentlichen rechtwinklig und vorzugsweise geradlinig vom Kühlkörper (10) abragen, und vorzugsweise die Kühlfinger (13) jeweils im Wesentlichen gleich geformt und regelmässig in zwei die Kontaktfläche (14) aufspannenden und im Wesentlichen rechtwinklig zueinander stehenden Flächenrichtungen (A,B) jeweils im Wesentlichen äquidistant angeordnet sind.

4. Leuchtdiodenarray (22) mit dem Kühlkörper (10) nach einem der vorangehenden Ansprüche, **dadurch gekennzeichnet, dass** die Kühlfinger (13) zylindrisch oder konisch geformt sind, jeweils eine Länge von 1 Millimeter bis 50 Millimeter und eine Materialstärke an einem kühlkörperseitigen Ende des Kühlfingers (13) von 0.3 Millimeter bis 10 Millimeter aufweisen und/oder dass ein Verhältnis dieser Länge zu dieser Materialstärke jeweils vorzugsweise 1:1 1 bis 30:1, insbesondere 20:1 bis 25:1 beträgt und wobei die Kühlfinger (13) vorzugsweise aus Vollmaterial bereitgestellt sind.

5. Leuchtdiodenarray (22) mit dem Kühlkörper (10) nach dem vorangehenden Anspruch, **dadurch gekennzeichnet, dass** unmittelbar benachbarte Kühlfinger (13) um das 0.5-Fache bis 5-Fache, vorzugsweise das 1-Fache der vorgenannten Materialstärke der Kühlfinger (13) voneinander beabstandet sind.

6. Leuchtdiodenarray (22) mit dem Kühlkörper (10) nach einem der vorangehenden Ansprüche, **dadurch gekennzeichnet, dass** die Kühlfinger (13) einstückig mit dem Kühlkörper (10) bereitgestellt sind oder in den Kühlkörper (10) eingesetzt sind.

7. Leuchtdiodenarray (22) mit dem Kühlkörper (10) nach einem der vorangehenden Ansprüche, **dadurch gekennzeichnet, dass** der Kühlkörper (10) und/oder die Kühlfinger (13) aus Metall, insbesondere aus Kupfer und/oder Aluminium und/oder einer Legierung daraus geformt sind und/oder dass eine Querschnittsgestalt der Kühlfinger (13), zumindest abschnittsweise, im Wesentlichen kreisrund, rund oder vieleckig, insbesondere vier- fünf-, sechs- oder achteckig ist.

8. Leuchtdiodenarray (22) mit dem Kühlkörper (10) nach einem der vorangehenden Ansprüche, **dadurch gekennzeichnet, dass** oder dass der Kühlkörper (10) kontaktflächenseitig eine vorzugsweise plattenförmige Ausnehmung (11) aufweist, wobei die Ausnehmung (11) zur Aufnahme des Leuchtdiodenarrays (22) dient.

9. Leuchtdiodenarray (22) mit dem Kühlkörper (10) nach einem der vorangehenden Ansprüche, **dadurch gekennzeichnet, dass** der Kühlkörper (10) eine vorzugsweise aus Vollmaterial gebildete Kühlplatte (12) umfasst, wobei diese Kühlplatte (12) vorzugsweise parallel verlaufende Flächen aufweist und jeweils flächenseitig die Kontaktfläche (14) und Teile der Kühlfläche (16) bereitstellt.

10. Leuchtdiodenarray (22) mit dem Kühlkörper (10) nach einem der vorangehenden Ansprüche, **dadurch gekennzeichnet, dass**, zumindest teilweise, eine Oberfläche der Kühlfläche (16) und/oder der Kühlfinger (13) aufgeraut und/oder strukturiert und/oder mit einer Deckschicht überzogen ist.

11. Kühlvorrichtung (5) mit einem Kühlkörper (10) und Kühlfingern (13) nach einem der vorangehenden Ansprüche für die Kühlung des Leuchtdiodenarray (22).

12. Kühlvorrichtung (5) nach dem vorangehenden Anspruch, **dadurch gekennzeichnet, dass** die Kühlvorrichtung (5) ein Zirkulationsgefäss (30) mit einem Kühlraum (32) umfasst, wobei dieses Zirkulationsgefäss (30) eine Montageöffnung (31) umfasst, in welche der Kühlkörper (10) vorzugsweise fluiddicht einsetzbar ist, derart, dass die Kühlfinger (13) zumindest teilweise in den Kühlraum (32) einragen und die Kontaktfläche (14) zumindest teilweise nach aussen freisteht.

13. Kühlvorrichtung (5) nach Anspruch 11 oder 12, **dadurch gekennzeichnet, dass** das Zirkulationsgefäss (30) weiter eine Einlassöffnung (34) in den Kühlraum (32) und eine Auslassöffnung (36) aus dem Kühlraum (32) umfasst und vorzugsweise aus Kunststoff oder Metall geformt ist, dass die Kühlvorrichtung (5) weiter einen Kühlkreislauf mit einem Kühlmedium, insbesondere einem Kühlfluid, vorzugsweise entionisiertem Wasser umfasst, wobei der Kühlkreislauf über die Einlassöffnung (34) und die Auslassöffnung (36) den Kühlraum (32) des Zirkulationsgefässes (30) derart umfasst, dass die in den Kühlraum (32) einragenden Kühlfinger (13) mit im Kühlkreislauf zirkulierendem Kühlmedium umspülbar bereitgestellt sind.

14. Kühlvorrichtung (5) nach einem der Ansprüche 11 bis 13, **dadurch gekennzeichnet, dass** die Kühlvorrichtung (5) weiter eine Zirkulationspumpe (40) zur Zirkulation des Kühlmediums im Kühlkreislauf und/oder ein Expansionsgefäss (50) zum Volumenausgleich und/oder einen Kondensator (60) zur Kühlung des Kühlmediums umfasst.

15. Verwendung eines Kühlkörpers (10) nach einem der Ansprüche 1 bis 10 oder einer Kühlvorrichtung (5) nach einem der Ansprüche 11 bis 14 zur Kühlung des Leuchtdiodenarrays (22) mit einer Vielzahl von einzelnen, flächenartig in einer Matrix angeordneten Leuchtdioden.
